# EUROPÄISCHE PATENTSCHRIFT

(11) **EP 3 834 006 B1**
(45) Veröffentlichungstag und Bekanntmachung des Hinweises auf die Patenterteilung: **02.07.2025**
(21) Anmeldenummer: 19733677.9
(22) Anmeldetag: 06.06.2019
(51) Int. Cl.: G01S 7/533, H03M 7/30, G01S 15/93, G01S 15/931, H04B 11/00

(54) **VERFAHREN UND VORRICHTUNG ZUM BEREITSTELLEN EINES DIGITALEN SENSORSIGNALS EINES ULTRASCHALLSENSORS**
METHOD AND DEVICE FOR PROVIDING A DIGITAL SENSOR SIGNAL OF AN ULTRASONIC SENSOR
PROCÉDÉ ET DISPOSITIF PERMETTANT D'OBTENIR UN SIGNAL DE CAPTEUR NUMÉRIQUE D'UN CAPTEUR À ULTRASONS

(30) Priorität: 10.08.2018 DE 102018119533
(43) Veröffentlichungstag der Anmeldung: 16.06.2021
(73) Patentinhaber: Valeo Schalter und Sensoren GmbH, 74321 Bietigheim-Bissingen (DE)
(72) Erfinder: THIN, Charles, 74321 Bietigheim-Bissingen (DE); BARIANT, Jean-Francois, 74321 Bietigheim-Bissingen (DE); MICHAEL, Anto, 74321 Bietigheim-Bissingen (DE)
(74) Vertreter: Pothmann, Karsten
(86) Internationale Anmeldenummer: PCT/EP2019/064748
(87) Internationale Veröffentlichungsnummer: WO 2020/030328

(56) Entgegenhaltungen:
- EP-A1- 1 631 091
- EP-A1- 3 171 553
- DE-B3- 102017 108 348

## Beschreibung

Die vorliegende Erfindung betrifft ein Verfahren zum Bereitstellen eines digitalen Sensorsignals eines Ultraschallsensors für eine signaltechnische Übertragung an einen Signalempfänger, bei dem ein -vorzugsweise digitales- Ausgangssignal des Ultraschallsensors zu dem digitalen Sensorsignal für die signaltechnische Übertragung verarbeitet wird.

Die Erfindung betrifft weiterhin eine entsprechende Vorrichtung zum Bereitstellen eines digitalen Sensorsignals eines Ultraschallsensors für eine signaltechnische Übertragung an einen Signalempfänger, eine entsprechende Ultraschallsensoreinrichtung mit Ultraschallsensor und derartiger Vorrichtung sowie ein entsprechendes Ultraschallsensorsystem.

Dokument DE 10 2017 108348 befasst sich mit der Konfiguration von Ultraschallsensorsystemen. Während der Konfiguration der Sensoren werden die Analog-Digital-Wandler-Parametereinstellungen optimiert, um bspw. optimale Erkennungsergebnisse oder eine Reduktion der zu übertragenden Daten zu erzielen. Dazu müssen die Analog-Digital-Wandler der Ultraschallsensoren einstellbaren Wandlerparameter aufweisen. Es werden unterschiedliche Bitraten oder auch eine Delta-Kodierung beschrieben.

Das Dokument DE 10 2008 044 058 B4 beschreibt ein Verfahren und ein System zum Bereitstellen eines digitalen Sensorsignals eines Ultraschallsensors für eine signaltechnische Übertragung per LIN-Kommunikation (LIN: Local Interconnect Network) an ein Steuergerät dieses Sensors. Dabei verarbeitet das System ein Ausgangssignal des Sensors zu dem digitalen Sensorsignal für die signaltechnische Übertragung per LIN-Kommunikation.

Die Begriffe Signalübertragung beziehungsweise signaltechnische Übertragung stehen allgemein für Informations- und Datenübertragung. Die Datenübertragung zwischen einem Ultraschallsensor und dem für diesen Sensor zuständigen Steuergerät (englisch: ECU: electronic control unit) in Kraftfahrzeugen erfolgt derzeit mittels standardisierter Übertragungsprotokolle, wie zum Beispiel dem Bus-Protokoll für LIN.

Die dazu verwendeten Übertragungssysteme sind in ihrer Datenrate begrenzt. Während der Ultraschallsensor selbst mithilfe eines Analog-zu-Digital-Umsetzer mit hoher Abtastrate und hoher Quantisierung, die Information der Membranschwingungen beim Empfang von Ultraschallsignal als Messsignal detailliert zur Verfügung hat, stehen in heutigen Systemen in dem Steuergerät nur stark verlustbehaftete Abbilder der tatsächlichen Messdaten zur Verfügung.

Die Datenrate der Übertragung zwischen Ultraschallsensor und Steuergerät ergibt sich dabei stets aus der verwendeten Abtastrate und der Quantisierung. Durch zu niedrige Abtastraten des im Folgenden als Ausgangssignal des Ultraschallsensors beziehungsweise Rohsignal bezeichneten Messsignals (wobei aus einer Reduzierung der Abtastrate auch eine Reduzierung der notwendigen Datenrate resultiert) entstehen wegen des Informationsverlustes Fehler wie zum Beispiel Aliasing oder eine stark verringerte Auflösung. Durch konventionelle Quantisierung mit geringer Bitzahl, in der Regel kleiner 5, wird ein hohes Quantisierungsrauschen erzeugt, was im schlimmsten Fall eine sinnvolle Verwertung der Daten verhindern kann. Eine Verbesserung des Quantisierungsrauschens kann unter Umständen durch nichtlineare Kennlinien erzielt werden. Jedoch ist auch dieser Ansatz durch die Anzahl der möglichen Quantisierungszustände, die aus den Quantisierungsbits resultieren, stark eingeschränkt.

Ausgehend von dem oben genannten Stand der Technik liegt der Erfindung somit die Aufgabe zugrunde, Maßnahmen anzugeben, die eine möglichst genaue Übertragung des Sensorsignals auch bei begrenzter Übertragungs-Bandbreite ermöglichen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Bei dem erfindungsgemäßen Verfahren zum Bereitstellen eines digitalen Sensorsignals eines Ultraschallsensors für eine signaltechnische Übertragung an einen Signalempfänger, bei dem ein - vorzugsweise digitales - Ausgangssignal des Ultraschallsensors zu dem digitalen Sensorsignal für die signaltechnische Übertragung verarbeitet wird, ist vorgesehen, dass die Verarbeitung die folgenden Schritte umfasst: (i) Ermittlung einer Signaländerung von aufeinander folgenden Werten des Ausgangssignals, (ii) Skalierung dieser Signaländerung mittels eines variablen Skalierungsfaktors, der von einem dem Ultraschallsensor und dem Signalempfänger bekannten Skalierungsschema vorgegeben wird und (iii) Ausgabe der skalierten Signaländerung als das digitale Sensorsignal. Mit anderen Worten wird statt einer (Re-) Skalierung der Werte des Ausgangssignals, also der Signalamplitude, eine Signaländerung von aufeinander folgenden Werten des Ausgangssignals ermittelt und skaliert.

Steht bei der signaltechnischen Übertragung eine hinreichend hohe Bandbreite zur Verfügung und ist der Dynamikbereich der sich ergebenden Signaländerung im Vorhinein bekannt, so braucht die Skalierung nur einmal festgelegt werden. Eine solche Situation liegt im Allgemeinen jedoch nicht vor.

Gemäß einer bevorzugten Ausführungsform der Erfindung weist die signaltechnische Übertragung an den Signalempfänger eine vorgegebene Bandbreite (Bitzahl) auf, wobei das Skalierungsschema die Größe des Skalierungsfaktors an diese vorgegebene Bandbreite anpasst. Die Notwendigkeit zur mehrmaligen (Um-)Skalierung ist in der Regel notwendig, da die Bandbreite bei der Übertragung deutlich zu klein für die Dynamik der Signaländerung ist. Wie eingangs erwähnt, ist die Bitzahl in der Regel geringer als 5. Bei einer Bitzahl von 3 kann nur eine Auflösung von 1/8 der Bandbreite erreicht werden. Der Tatsache, dass die hier zu übertragende Signaländerung eine relativ hohe Dynamik aufweist, muss durch Ändern des Skalierungsfaktors, also Umskalieren, Rechnung getragen werden.

Damit nun nicht zusätzlich auch noch der Skalierungsfaktor bei der signaltechnischen Übertragung an den Signalempfänger mit übertragen werden muss, wird der variable Skalierungsfaktor gemäß eines Skalierungsschemas festgelegt, welches sowohl dem Ultraschallsensor als auch dem Signalempfänger gleichermaßen bekannt ist.

Der Skalierungsfaktor wird insbesondere derart anpasst, dass die Signaländerung mit der vorgegebenen Bandbreite voraussichtlich korrekt übertragbar ist. Dabei sind zwei Faktoren von besonderem Interesse: (i) Das Kriterium, wann eine Anpassung als notwendig erachtet wird und (ii) die "Schrittweite" der Anpassung.

Gemäß einer weiteren bevorzugten Ausführungsform der Erfindung ist vorgesehen, dass gemäß des Skalierungsschemas die Größe des Skalierungsfaktors für zwei aufeinander folgende Werte einer fortlaufenden Folge von Werten an die vorgegebene Bandbreite anpasst wird, wenn die skalierte Signaländerung der letzten beiden zuvor berücksichtigten Werte der fortlaufenden Folge die Bandbreite zu einem Anteil ausnutzt, der in zumindest einem vorgegebenen Bereich liegt. In der Regel sind zwei solche Bereiche vorgesehen. Liegt die skalierte Signaländerung im ersten Bereich, so wird hochskaliert, also ein höherer Skalierungsfaktor als zuvor verwendet, liegt die skalierte Signaländerung im zweiten Bereich, so wird herunterskaliert, also ein niedriger Skalierungsfaktor als zuvor verwendet. Der erste Bereich ist ein Bereich von 0 bis x mal der Bandbreite und der zweite Bereich ist ein Bereich von y bis 1 mal der Bandbreite, wobei für x 0.1 < x < 0.33 und 0.66 < y < 0.9 gilt. Beispielsweise ist vorgesehen, dass durch Vergrößerung des Skalierungsfaktors heraufskaliert wird, wenn die Bandbreite zu weniger als 20% (x = 0.2) ausgenutzt wird und dass durch Verkleinerung des Skalierungsfaktors herunterskaliert wird, wenn die Bandbreite zu mehr als 80% (y = 0.8) ausgenutzt wird.

Die Anpassung des Skalierungsfaktors gemäß Skalierungsschema ist nun nur von der letzten skalierten Signaländerung SC, also der letzten ermittelten und anschließend nach dem Schema skalierten Signaländerung, abhängig. Da sowohl der Vorrichtung zum Erstellen eines digitalen Sensorsignals als auch dem Signalempfänger das Skalierungsschema bekannt ist, ist für beide -neben dem Schema selbst - keine weitere Information notwendig, um das Signal zu kodieren/dekodieren.

Das Skalierungsschema ist also ein Skalierungsschema, bei dem sich der Skalierungsfaktor allein aus dem letzten zuvor verarbeiteten skalierten Signaländerungswert ergibt.

Insbesondere ist vorgesehen, dass die Größe des Skalierungsfaktors bei der Anpassung mindestens um den Faktor zwei vergrößert oder verkleinert wird. Vorzugsweise wird die Größe des Skalierungsfaktors bei der Anpassung im Bereich einer ganzen Größenordnung, also im Bereich des Faktors 10, vergrößert oder verkleinert. Die Anpassung ist mit anderen Worten hochdynamisch, sodass das Ausgangssignal des Ultraschallsensors auch bei sehr geringer Bandbreite korrekt übertragen werden kann.

Gemäß einer weiteren bevorzugten Ausführungsform der Erfindung ist vorgesehen, dass die Signaländerung des Ausgangssignals mittels einer Subtraktion ermittelt wird. Eine solche Subtraktion kann mittels eines Subtrahierer-Bausteins auf einfache Weise erfolgen.

Gemäß noch einer weiteren bevorzugten Ausführungsform der Erfindung ist vorgesehen, dass die signaltechnische Übertragung eine Datenübertragung über ein BUS-System, insbesondere ein LIN-Bussystem, ist. Das Local Interconnect Network (LIN), auch LIN-Bus genannt, ist ein serielles Kommunikationssystem für die Vernetzung von Sensoren und Aktoren, also ein Feldbus. Der LIN-Bus kommt insbesondere dort zum Einsatz, wo die Bandbreite und Vielseitigkeit eines CAN-Bussystems (CAN: Controller Area Network) nicht benötigt wird. Typische Anwendungsbeispiele sind die Vernetzung innerhalb eines Kraftfahrzeugbereichs.

Mit Vorteil ist dabei die Datenübertragung eine Datenübertragung gemäß DSI3-Busprotokoll. Das Distributed Systems Interface (DSI) ist ein Busprotokoll, welches dazu dient, mehrere verteilte Systeme, Sensoren und Aktuatoren an ein zentrales Steuergerät anzuschließen. Es ist somit eines, wenn nicht das, für diese Anwendung prädestinierte Protokoll.

Bei der erfindungsgemäßen Vorrichtung zum Bereitstellen eines digitalen Sensorsignals eines Ultraschallsensors für eine signaltechnische Übertragung an einen Signalempfänger, welche zum Verarbeiten eines - vorzugsweise digitalen - Ausgangssignals des Ultraschallsensors zu dem digitalen Sensorsignal für die signaltechnische Übertragung eingerichtet ist, ist vorgesehen, dass die Vorrichtung dazu eingerichtet ist: (i) eine Signaländerung von aufeinander folgenden Werten des Ausgangssignals zu ermitteln, (ii) dieser Signaländerung mittels eines variablen Skalierungsfaktors, der von einem dem Ultraschallsensor und dem Signalempfänger bekannten Skalierungsschema vorgegeben wird, zu skalieren und (iii) die skalierte Signaländerung als das digitale Sensorsignal auszugeben.

Die zuvor im Rahmen der Beschreibung des Verfahrens genannten Ausführungsformen der Erfindung gelten entsprechend auch für die Vorrichtung.

Gemäß einer bevorzugten Ausführungsform der erfindungsgemäßen Vorrichtung ist vorgesehen, dass diese zur Durchführung des vorstehend genannten Verfahrens eingerichtet ist.

Bei der erfindungsgemäßen Ultraschallsensoreinrichtung mit einem Ultraschallsensor ist vorgesehen, dass diese weiterhin eine vorgenannte Vorrichtung zum Erstellen eines digitalen Sensorsignals des Ultraschallsensors aufweist, die dem Ultraschallsensor signaltechnisch nachgeschaltet ist.

Bei dem erfindungsgemäßen Ultraschallsensorsystem für ein Kraftfahrzeug, mit zumindest einem Ultraschallsensor und einem Signalempfänger, insbesondere einem Steuergerät, ist vorgesehen, dass dieses Ultraschallsensorsystem weiterhin zumindest eine vorgenannte Vorrichtung zum Erstellen eines digitalen Sensorsignals des Ultraschallsensors aufweist.

Nachfolgend wird die Erfindung unter Bezugnahme auf die anliegenden Zeichnungen anhand bevorzugter Ausführungsformen näher erläutert.

Es zeigt
- Fig. 1: ein Kraftfahrzeug, welches ein Fahrerassistenzsystem mit einer Ultraschallsensorvorrichtung gemäß einer Ausführungsform der Erfindung aufweist,
- Fig. 2: ein Ersatzschaltbild einer Vorrichtung zum Erstellen eines digitalen Sensorsignals eines Ultraschallsensors gemäß einer Ausführungsform der Erfindung und
- Fig. 3: einen Vergleich eines ursprünglichen Sensorausgangssignals und eines nach einer Übertragung rekonstruierten Signals in zeitabhängiger Darstellung.

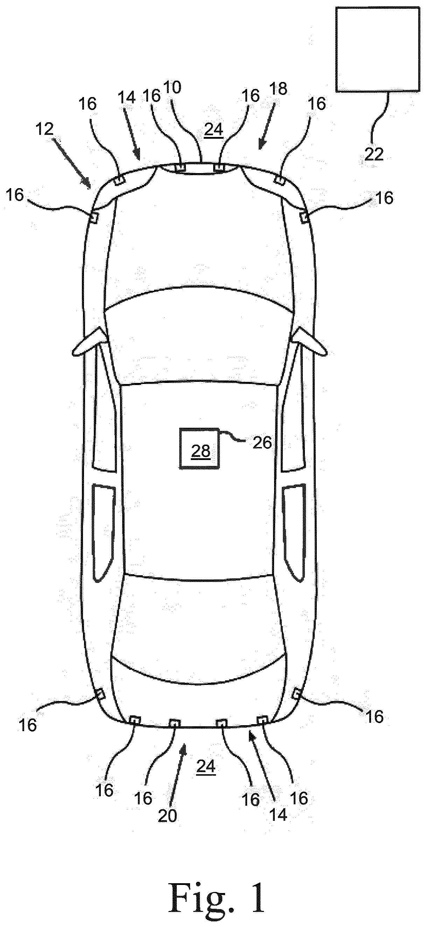

Fig. 1 zeigt ein vorliegend als Personenkraftwagen ausgebildetes Kraftfahrzeug 10 in einer Draufsicht. Das Kraftfahrzeug 10 umfasst ein Fahrerassistenzsystem 12, welches dazu dient, einen Fahrer beim Führen des Kraftfahrzeugs 10 zu unterstützen. Insbesondere kann das Fahrerassistenzsystem 12 als Parkhilfesystem ausgebildet sein, mittels welchem der Fahrer beim Einparken des Kraftfahrzeugs 10 in eine Parklücke und/oder beim Ausparken aus der Parklücke unterstützt werden kann.

Das Fahrerassistenzsystem 12 umfasst wiederum eine Ultraschallsensorsystem 14. Das Ultraschallsensorsystem 14 weist zumindest einen Ultraschallsensor 16 auf. In dem vorliegenden Ausführungsbeispiel umfasst die Ultraschallsensorvorrichtung 14 zwölf Ultraschallsensoren 16. Dabei sind sechs Ultraschallsensoren 16 in einem Frontbereich 18 des Kraftfahrzeugs 10 und sechs Ultraschallsensoren 16 in einem Heckbereich 20 des Kraftfahrzeugs 10 angeordnet. Die Ultraschallsensoren 16 können insbesondere an den Stoßfänger des Kraftfahrzeugs 10 montiert sein. Dabei können die Ultraschallsensoren 16 zumindest bereichsweise in entsprechenden Ausnehmungen beziehungsweise Durchgangsöffnungen der Stoßfänger angeordnet sein. Es kann auch vorgesehen sein, dass die Ultraschallsensoren 16 verdeckt hinter den Stoßfänger angeordnet sind. Grundsätzlich können die Ultraschallsensoren 16 auch an weiteren Verkleidungsteilen des Kraftfahrzeugs 10 angeordnet sein. Beispielsweise können die Ultraschallsensoren 10 an oder verdeckt hinter den Türen des Kraftfahrzeugs 10 angeordnet sein.

Mithilfe der jeweiligen Ultraschallsensoren 16 können Sensorsignale bereitgestellt werden, welche zumindest ein Objekt 22 in einem Umgebungsbereich 24 des Kraftfahrzeugs 1 beschreiben. Vorliegend ist schematisch ein Objekt 22 in dem Umgebungsbereich 24 gezeigt. Zum Bestimmen des Sensorsignals kann mit jedem der Ultraschallsensoren 16 ein Ultraschallsignal ausgesendet werden. Im Anschluss daran kann das von dem Objekt 22 reflektierte Ultraschallsignal wieder empfangen werden. Anhand der Laufzeit zwischen dem Aussenden des Ultraschallsignals und dem Empfangen des von dem Objekt 22 reflektierten Ultraschallsignals kann dann ein Abstand zwischen dem Ultraschallsensor 16 und dem Objekt 22 bestimmt werden. Es kann auch vorgesehen sein, dass die jeweiligen Abstände, die mit unterschiedlichen Ultraschallsensoren 16 bestimmt werden, berücksichtigt werden. Somit kann mittels Trilateration die relative Lage zwischen dem Kraftfahrzeug 10 und dem Objekt 22 bestimmt werden. Es kann auch vorgesehen sein, dass das Ultraschallsignal, das von einem der Ultraschallsensoren 16 ausgesendet wurde, mit einem anderen der Ultraschallsensoren 16 empfangen wird. Dies wird auch als Kreuzmessung bezeichnet.

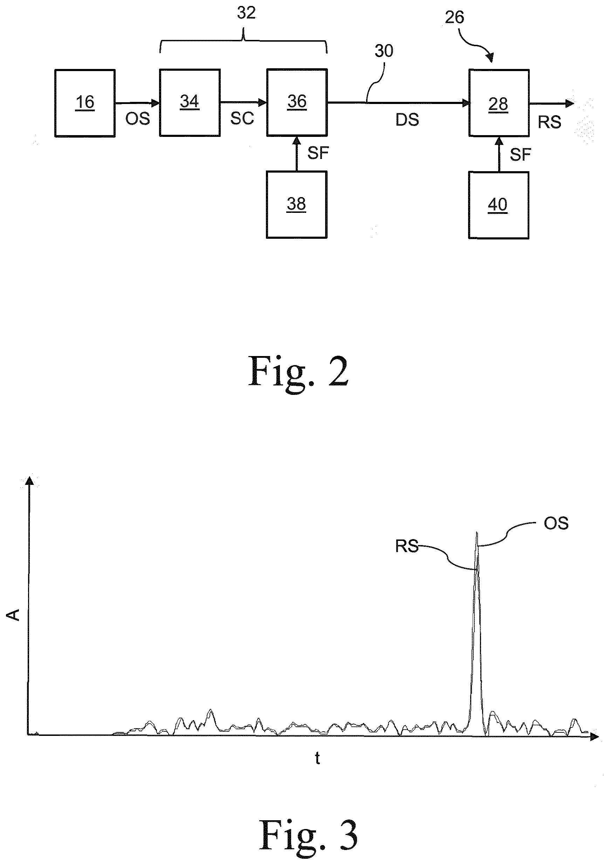

Des Weiteren umfasst das Ultraschallsensorsystem 14 ein elektronisches Steuergerät 26 als Signalempfänger 28, welches mit den Ultraschallsensoren 16 zur Datenübertragung über eine Datenleitung 30 beziehungsweise ein Bussystem verbunden ist (die Leitung 30 ist in Fig. 2 gezeigt). Über die Datenleitung 30 können die mit den jeweiligen Ultraschallsensoren 16 bestimmten Sensorsignale an das Steuergerät 26 als Signalempfänger 28 übertragen werden. Anhand der Sensorsignale kann das Steuergerät 26 überprüfen, ob sich das Objekt 22 in dem Umgebungsbereich 24 befindet und an welcher Position sich das Objekt 22 in dem Umgebungsbereich 24 befindet. Diese Information kann dann von dem Fahrerassistenzsystem 12 genutzt werden, um eine Ausgabe an den Fahrer des Kraftfahrzeugs 10 auszugeben. Zudem kann es vorgesehen sein, dass das Fahrerassistenzsystem 12 in eine Lenkung, ein Bremssystem und/oder einen Antriebsmotor eingreift, um das Kraftfahrzeug 10 in Abhängigkeit von dem zumindest einen erfassten Objekt 22 autonom oder zumindest semi-autonom zu manövrieren.

Fig. 2 zeigt eine Vorrichtung 32 zum Bereitstellen eines digitalen Sensorsignals DS eines Ultraschallsensors 16 aus dem im Folgenden als Ausgangssignal (oder Rohsignal) OS bezeichneten ursprünglichen Messsignal des Sensors 16. Das digitale Sensorsignal DS wird dann beispielsweise über eine LIN-Bus (LIN: Local Interconnect Network) Datenleitung 30 an das Steuergerät 26 als Signalempfänger 28 übertragen. Die Vorrichtung 32 verarbeitet dazu das Ausgangssignal OS des Ultraschallsensors 16 zu einem digitalen Sensorsignal DS für eine signaltechnische Übertragung mit begrenzter Übertragungsrate. Dabei erfolgt eine Ermittlung einer Signaländerung SC von aufeinander folgenden Werten (beziehungsweise Amplituden) des Ausgangssignals OS mittels eines Subtrahierers 34 und eines (hier nicht gezeigten) Haltegliedes, welches den vorherigen Wert des Ausgangssignals OS vorhält, sodass mittels des Subtrahierers 34 die Differenz des vorherigen und des aktuellen Werts des Ausgangssignals OS, also die Signaländerung SC des Ausgangssignals OS ermittelt wird. Diese Signaländerung SC wird dann mittels eines Skalierers 36 entsprechend skaliert und als das digitale Sensorsignal DS zur Übertragung zur Verfügung gestellt. Der Skalierer 36 ist dabei eine Art Quantisierer, bei dem die Quantisierungsschrittweite skalierbar/einstellbar ist.

Eine Skalierung von Amplitudenwerten des Signals OS (statt der hier durchgeführten Skalierung der Signaländerungen SC) besitzt insbesondere bei Ultraschallechos den Nachteil, dass durch Nachschwingen der Membranen beim Senden hohe Amplitudenausschläge erzeugt werden, während die Ausgangssignale RS von Umgebungsechos meist deutlich geringer ausfallen.

Die Skalierung der Signaländerung SC erfolgt über einen variablen Skalierungsfaktor SF, der von einem dem Ultraschallsensor 16 und dem Signalempfänger 28 bekannten Skalierungsschema vorgegeben wird. Dieses Skalierungsschema ist als Skalierungsanpassungsprotokoll sowohl in einem Datenspeicher 38 der Vorrichtung 32 zum Erstellen des digitalen Sensorsignals DS als auch in einem Datenspeicher 40 des Steuergerätes 26 hinterlegt.

Gemäß des Skalierungsschemas wird die Größe des Skalierungsfaktors SF für zwei aufeinander folgende Werte einer fortlaufenden Folge von Werten an die vorgegebene Bandbreite anpasst, wenn die skalierte Signaländerung der letzten beiden zuvor berücksichtigten Werte der fortlaufenden Folge die Bandbreite zu einem Anteil ausnutzt, der in zumindest einem vorgegebenen Bereich am oberen Ende oder am unteren Ende der Bandbreite liegt. Wird die Bandbreite aktuell nur zu einem geringen Anteil ausgenutzt, beispielsweise unter 20%, so wird hinaufskaliert, wird die Bandbreite aktuell zu einem hohen Anteil genutzt, beispielsweise über 80%, so wird herunterskaliert.

Die Fig. 3 zeigt einen Vergleich des ursprünglichen Sensorausgangssignals OS und eines aus dem übertragenen digitalen Sensorsignal DS rekonstruierten Signals RS in einer zeitabhängigen Darstellung. Mit anderen Worten sind hier das ursprüngliche Sensorausgangssignal OS und ein aus dem übertragenen digitalen Sensorsignal DS rekonstruiertes Signals RS jeweils als Graph dargestellt, wobei die jeweilige Signalamplitude A über der Zeit t aufgetragen ist. Das hier gezeigte rekonstruierte Signals RS ergibt sich aus einem digitalen Sensorsignal DS, welches per DSI-Busbetrieb übertagen wurde, wobei die Abtastungsfrequenz erst durch zwei dividiert, dann mit DSI3 gemäß dem beschriebenen Verfahren enkodiert und dekodiert wurde.

Dieser Vergleich zeigt, wie gut das so rekonstruierte Signals RS dem ursprünglichen Sensorausgangssignal OS selbst bei nur 3 Bit folgt.

Im Folgenden sollen die Eigenschaften und die vorteilhaften Wirkungen des hier beschriebenen Vorgehens noch einmal mit anderen Worten kurz skizziert werden:
Die Sensorelektronik liefert eine Abtastung der Vibrationsamplitude mit einer bestimmten Frequenz (Graph OS in Fig. 3). Anstatt der Abtastwerte der Vibrationsamplitude werden die Differenzen zwischen zwei aufeinanderfolgenden Abtastwerten der Vibrationsamplitude, also die Signaländerung SC (als digitales Sensorsignal DS) übertragen.

Jeder Differenzwert, also jede Signaländerung SC, wird auf eine feste Anzahl von Bits kodiert (im Beispiel: 3 Bits).

Die Skalierung der Differenzwerte (Signaländerung SC) auf die 3 Bits ist jedoch flexibel und folgt einem von jeder Seite (der Ultraschallsensoreinrichtung 16, 32 als Sender und dem Steuergerät 26 als Empfänger) bekannten Protokoll, dem Skalierungsschema.

Die Anpassung gemäß Skalierungsanpassungsprotokoll bzw. Skalierungsschema ist nur von der letzten übertragenen 3-Bit skalierten Signaländerung SC abhängig. Da auch dem Empfänger das Skalierungsanpassungsprotokoll bzw. Skalierungsschema bekannt ist, ist es nicht notwendig eine weitere Information zu übertragen.

Das Skalierungsanpassungsprotokoll nimmt als Eingang den letzten 3-Bit Differenzwert und den letzten sogenannten Skalierungsfaktor SF ("scaling level", der im Folgenden einfach als n bezeichnet wird, wobei das Skalierungsanpassungsprotokoll bzw. Skalierungsschema lokal bei dem Sender und dem Empfänger gespeichert ist) und ergibt als Ausgang einen neuen, angepassten Skalierungsfaktor SF. Bei besagten 3 Bit ergibt sich zum Beispiel :
- Werte 0 und 7 (stärkste Steigerung / stärkstes Fallen) : n = n + step_up (z. B. step_up = 4);
- Werte 3, 4 und 5 (kleine bis keine Steigerung / geringes bis kein Fallen) : n = n - step_down (z. B. step_down = 2);
- n wird zwischen 1 und max_scaling_level begrenzt (z. B. max_scaling_level = 12);
- Zu jedem Skalierungsniveau gehört einen Amplitudenwert, hier als f(n) bezeichnet (wobei n der Skalierungsfaktor ist).
- Es wird eine lineare Konvertierung von Differenzwert auf 3 Bits verwendet, mit Hauptfaktor f(n), zum Beispiel :
   - Wert 3 auf 3 Bits (011) gibt einen Differenzwert zwischen -f(n)/2 und +f(n)/2 (also mehr oder weniger keinen Differenz überhaupt);
   - Wert 7 gibt einen Differenzwert größer als 4*f(n) - f(n)/2 (größter darstellbarer Differenz, Wert auf 3 Bits erreicht Sättigung);
   - Wert 0 gibt einen Differenzwert kleiner als -3*f(n) + f(n)/2 (kleinster darstellbarer Differenz, Wert auf 3 Bits erreicht Sättigung); und so weiter.
   - Beispiel für f: f(n) = scaling_factor*n3/2 (z. B. scaling_factor = 4).

Die Werten f(n) für alle n zwischen 1 und max_scaling_level werden im Voraus berechnet (z. B. bei der Initialisierung) um Laufzeit bei der Enkodierung / Dekodierung zu sparen. Diese Beispielvariante für f erlaubt auch eine schnelle Steigerung der Skalierung wenn n steigt.
- Beim Enkodieren wird parallel der Wert berechnet, den der Empfänger 28 dekodieren würde, und damit ist die Differenz mit dem nächsten Abtastwert gerechnet. Das verbessert die allgemeine Genauigkeit des ganzen Enkodier-/Dekodier-Prozess und sorgt für mögliches langsames Driften beim Dekodieren.
- Es wird beim Dekodieren angenommen, dass den ersten Wert 0 ist. Diese Annahme ist der Realität in den meisten Fällen angemessen. Damit muss am Anfang auch kein Startwert verschickt werden. Schon der erste übertragende Wert des übertragenen digitalen Signals DS kann ein erster Differenzwert sein, nämlich der Differenzwert zwischen 0 und dem zweiten Abtastwert der Amplitude.

### Bezugszeichenliste

| | |
|---|---|
| Kraftfahrzeug | 10 |
| Fahrerassistenzsystem | 12 |
| Ultraschallsensorsystem | 14 |
| Ultraschallsensor | 16 |
| Frontbereich | 18 |
| Heckbereich | 20 |
| Objekt | 22 |
| Umgebungsbereich | 24 |
| Steuergerät | 26 |
| Signalempfänger | 28 |
| Datenleitung | 30 |
| Vorrichtung zum Erstellen eines digitalen Sensorsignals | 32 |
| Subtrahierer | 34 |
| Skalierer | 36 |
| Datenspeicher | 38 |
| Datenspeicher | 40 |
| Amplitude | A |
| Digitales Sensorsignal zur Übertragung | DS |
| Ausgangssignal des Sensors | OS |
| Rekonstruiertes Signal am Signalempfänger | RS |
| Signaländerung (Ausgangssignal) | SC |
| Skalierungsfaktor | SF |
| Zeit | t |

## Patentansprüche

1. Verfahren zum Bereitstellen eines digitalen Sensorsignals (DS) eines Ultraschallsensors (16) für eine signaltechnische Übertragung an einen Signalempfänger (28), bei dem ein - vorzugsweise digitales - Ausgangssignal (OS) des Ultraschallsensors (16) zu dem digitalen Sensorsignal für die signaltechnische Übertragung verarbeitet wird,
**dadurch gekennzeichnet, dass** die Verarbeitung die folgenden Schritte umfasst:
- Ermittlung einer Signaländerung (SC) von aufeinander folgenden Werten des Ausgangssignals (OS),
- Skalierung dieser Signaländerung (SC) mittels eines variablen Skalierungsfaktors (SF), der von einem dem Ultraschallsensor (16) und dem Signalempfänger (28) bekannten Skalierungsschema vorgegeben wird und
- Ausgabe der skalierten Signaländerung (SC) als das digitale Sensorsignal (DS).

2. Verfahren nach Anspruch 1, **dadurch gekennzeichnet, dass** die signaltechnische Übertragung an den Signalempfänger (28) eine vorgegebene Bandbreite aufweist und die Größe des Skalierungsfaktors (SF) mittels des Skalierungsschemas an diese vorgegebene Bandbreite angepasst wird.

3. Verfahren nach Anspruch 2, **dadurch gekennzeichnet, dass** gemäß des Skalierungsschemas die Größe des Skalierungsfaktors (SF) für zwei aufeinander folgende Werte einer fortlaufenden Folge von Werten des Ausgangssignals (OS) an die vorgegebene Bandbreite anpasst wird, wenn die skalierte Signaländerung der letzten beiden zuvor berücksichtigten Werte der fortlaufenden Folge die Bandbreite zu einem Anteil ausnutzt, der in zumindest einem vorgegebenen Bereich liegt.

4. Verfahren nach einem der Ansprüche 1 bis 3, **dadurch gekennzeichnet, dass** die Größe des Skalierungsfaktors (SF) bei der Anpassung mindestens um den Faktor zwei vergrößert oder verkleinert wird.

5. Verfahren nach einem der Ansprüche 1 bis **4, dadurch gekennzeichnet, dass** die Signaländerung (SC) des Ausgangssignals (OS) mittels einer Subtraktion ermittelt wird.

6. Verfahren nach einem der Ansprüche 1 bis 5, **dadurch gekennzeichnet, dass** die signaltechnische Übertragung eine Datenübertragung über ein BUS-System, insbesondere ein LIN-Bussystem, ist.

7. Verfahren nach Anspruch 6, **dadurch gekennzeichnet, dass** die Datenübertragung eine Datenübertragung gemäß DSl3-Busprotokoll ist.

8. Vorrichtung (32) zum Bereitstellen eines digitalen Sensorsignals (DS) eines Ultraschallsensors (16) für eine signaltechnische Übertragung an einen Signalempfänger (28), wobei die Vorrichtung (32) zum Verarbeiten eines - vorzugsweise digitalen - Ausgangssignals (OS) des Ultraschallsensors (16) zu dem digitalen Sensorsignal (DS) für die signaltechnische Übertragung eingerichtet ist,
**dadurch gekennzeichnet, dass** die Vorrichtung (32) eingerichtet ist eine Signaländerung (SC) von aufeinander folgenden Werten des Ausgangssignals (RS) zu ermitteln, dieser Signaländerung (SC) mittels eines variablen Skalierungsfaktors (SF), der von einem dem Ultraschallsensor (16) und dem Signalempfänger (26) bekannten Skalierungsschema vorgegeben wird, zu skalieren und die skalierte Signaländerung (SC) als das digitale Sensorsignal (DS) auszugeben.

9. Ultraschallsensoreinrichtung mit einem Ultraschallsensor (16) und einer dem Ultraschallsensor (16) signaltechnisch nachgeschalteten Vorrichtung (32) nach Anspruch 8.

10. Ultraschallsensorsystem (14) für ein Kraftfahrzeug (10), mit zumindest einem Ultraschallsensor (16), einem Signalempfänger (28), insbesondere einem Steuergerät (26), und zumindest einer Vorrichtung (32) nach Anspruch 8.

## Claims

1. Method for providing a digital sensor signal (DS) from an ultrasonic sensor (16) for signal transmission to a signal receiver (28), in which a - preferably digital
- output signal (OS) from the ultrasonic sensor (16) is processed to form the digital sensor signal for signal transmission,
**characterized in that** the processing comprises the following steps:
- determining a signal change (SC) of successive values of the output signal (OS),
- scaling this signal change (SC) by means of a variable scaling factor (SF) which is specified by a scaling scheme known to the ultrasonic sensor (16) and the signal receiver (28), and
- outputting the scaled signal change (SC) as the digital sensor signal (DS).

2. Method according to Claim 1, **characterized in that** the signal transmission to the signal receiver (28) has a predefined bandwidth and the size of the scaling factor (SF) is adapted to this predefined bandwidth by means of the scaling scheme.

3. Method according to Claim 2, **characterized in that** the size of the scaling factor (SF) for two successive values in a continuous sequence of values of the output signal (OS) is adapted to the predefined bandwidth according to the scaling scheme if the scaled signal change of the last two previously considered values in the continuous sequence uses a portion of the bandwidth that is in at least a predefined range.

4. Method according to one of Claims 1 to 3, **characterized in that** the size of the scaling factor (SF) is increased or decreased at least by a factor of two during the adaptation.

5. Method according to one of Claims 1 to 4, **characterized in that** the signal change (SC) of the output signal (OS) is determined by means of a subtraction.

6. Method according to one of Claims 1 to 5, **characterized in that** the signal transmission is a data transmission via a BUS system, in particular a LIN bus system.

7. Method according to Claim 6, **characterized in that** the data transmission is a data transmission according to the DSI3 bus protocol.

8. Apparatus (32) for providing a digital sensor signal (DS) from an ultrasonic sensor (16) for signal transmission to a signal receiver (28), the apparatus (32) being configured to process a - preferably digital
- output signal (OS) from the ultrasonic sensor (16) to form the digital sensor signal (DS) for signal transmission,
**characterized in that** the apparatus (32) is configured to determine a signal change (SC) of successive values of the output signal (RS), to scale this signal change (SC) by means of a variable scaling factor (SF) which is specified by a scaling scheme known to the ultrasonic sensor (16) and the signal receiver (26), and to output the scaled signal change (SC) as the digital sensor signal (DS).

9. Ultrasonic sensor device with an ultrasonic sensor (16) and an apparatus (32) according to Claim 8 connected downstream of the ultrasonic sensor (16) in terms of signalling.

10. Ultrasonic sensor system (14) for a motor vehicle (10), with at least one ultrasonic sensor (16), a signal receiver (28), in particular a control unit (26), and at least one apparatus (32) according to Claim 8.

## Revendications

1. Procédé permettant d'obtenir un signal de capteur numérique (DS) d'un capteur à ultrasons (16) pour une transmission technique de signaux à un récepteur de signaux (28), dans lequel un signal de sortie (OS) - de préférence numérique - du capteur à ultrasons (16) est traité pour former le signal de capteur numérique en vue de la transmission technique de signaux,
**caractérisé en ce que** le traitement comprend les étapes suivantes :
- détermination d'une variation de signal (SC) de valeurs successives du signal de sortie (OS),
- mise à l'échelle de cette variation de signal (SC) au moyen d'un facteur de mise à l'échelle variable (SF), qui est donné par un schéma de mise à l'échelle connu du capteur à ultrasons (16) et du récepteur de signaux (28), et
- délivrance en sortie de la variation de signal mise à l'échelle (SC) en tant que le signal de capteur numérique (DS).

2. Procédé selon la revendication 1, **caractérisé en ce que** la transmission technique du signal au récepteur de signaux (28) présente une largeur de bande prédéterminée et la valeur du facteur de mise à l'échelle (SF) est adaptée à cette largeur de bande prédéterminée au moyen du schéma de mise à l'échelle.

3. Procédé selon la revendication 2, **caractérisé en ce que**, selon le schéma de mise à l'échelle, la valeur du facteur de mise à l'échelle (SF) est adaptée à la largeur de bande prédéterminée pour deux valeurs successives d'une séquence continue de valeurs du signal de sortie (OS), lorsque la variation de signal mise à l'échelle des deux =- dernières valeurs de la séquence continue précédemment prises en compte utilise la largeur de bande dans une proportion qui se situe dans au moins une plage prédéterminée.

4. Procédé selon l'une des revendications 1 à 3, **caractérisé en ce que** la valeur du facteur de mise à l'échelle (SF) est augmentée ou diminuée d'au moins un facteur deux lors de l'adaptation.

5. Procédé selon l'une des revendications 1 à 4, **caractérisé en ce que** la modification (SC) du signal de sortie (OS) est déterminée au moyen d'une soustraction.

6. Procédé selon l'une des revendications 1 à 5, **caractérisé en ce que** la transmission technique du signal est une transmission de données via un système de BUS, en particulier un système de bus LIN.

7. Procédé selon la revendication 6, **caractérisé en ce que** la transmission de données est une transmission de données selon le protocole de bus DSI3.

8. Dispositif (32) permettant d'obtenir un signal de capteur numérique (DS) d'un capteur à ultrasons (16) pour une transmission technique de signaux à un récepteur de signaux (28), le dispositif (32) étant conçu pour traiter un signal de sortie (OS) - de préférence numérique - du capteur à ultrasons (16) pour obtenir le signal de capteur numérique (DS) pour la transmission technique de signaux,
**caractérisé en ce que** le dispositif (32) est conçu pour déterminer une variation de signal (SC) de valeurs successives du signal de sortie (RS), pour mettre à l'échelle cette variation de signal (SC) au moyen d'un facteur de mise à l'échelle variable (SF) qui est prédéfini par un schéma de mise à l'échelle connu du capteur à ultrasons (16) et du récepteur de signaux (26), et pour émettre la variation de signal mise à l'échelle (SC) en tant que signal de capteur numérique (DS).

9. Dispositif de capteur à ultrasons avec un capteur à ultrasons (16) et un dispositif (32) monté en aval du capteur à ultrasons (16) en termes de technique de signalisation selon la revendication 8.

10. Système (14) de capteur à ultrasons pour un véhicule automobile (10), comprenant au moins un capteur à ultrasons (16), un récepteur de signaux (28), notamment un appareil de commande (26), et au moins un dispositif (32) selon la revendication 8.
